# EUROPEAN PATENT APPLICATION

(11) **EP 4 852 239 A1**
(43) Date of publication of application: **09.12.2026**
(21) Application number: 24921977.5
(22) Date of filing: 26.11.2024
(51) Int. Cl.: H01S 5/20, H01S 5/22, H01S 5/028, H01S 5/042

(54) **SEMICONDUCTOR LASER ELEMENT**

(30) Priority: 01.02.2024 JP 2024014439
(71) Applicant: USHIO DENKI KABUSHIKI KAISHA, Tokyo 108-0073 (JP)
(72) Inventor: SAKAI, Shigeta, Tokyo 108-0073 (JP); INOUE, Yutaka, Tokyo 108-0073 (JP); FUKAI, Haruki, Tokyo 108-0073 (JP)
(74) Representative: TBK
(86) International application number: PCT/JP2024/041705
(87) International publication number: WO 2025/164059

(57) **Abstract**

Provided is a semiconductor laser element in which peeling of an insulating film and a wiring is unlikely to occur. A laser waveguide (200) extends in a first direction (y-direction). On a surface of a semiconductor laser element (100), a groove (190) extending in the first direction (y-direction) is formed. The groove (190) includes, in cross-sectional view, a first portion (192) having a relatively narrow width in a second direction (x-direction), and a second portion (194) located deeper than the first portion (192) and having a relatively wide width in the second direction (x-direction). In at least a part of the first direction (y-direction), a surface of the groove (190) is continuously covered in a direction crossing the groove (190) by a connection wiring (Lc), which is a metal, or a contact insulating film (160), which is an insulating material.

## Description

### TECHNICAL FIELD

The present disclosure relates to a semiconductor laser element.

### BACKGROUND OF INVENTION

A semiconductor laser is used as a light source in an electronic device such as a printer or a head-mounted display (HMD). To accommodate higher resolution of such an electronic device that handles an image, a multi-beam semiconductor laser element is adopted.

To miniaturize a lens and a MEMS mirror, it is required to narrow a beam pitch. In response to the beam pitch becoming narrower than a ball diameter of wire bonding or a solder pattern width of die bonding, it becomes impossible to secure an area for directly wire-bonding or die-bonding to an electrode on an upper surface of a laser waveguide, and as a result, it is necessary to form an electrode pad close to an edge of a chip (semiconductor substrate). In this case, a connection wiring (multilayer wiring) connecting between the electrode pad and the laser waveguide crosses over the laser waveguide (Patent Literature 1).

Specifically, the connection wiring connecting a power supply electrode (P-side electrode) formed on an upper surface of a central laser waveguide and the electrode pad crosses an adjacent laser waveguide. Focusing on an intersection portion of the connection wiring and the laser waveguide, an interlayer insulating film is inserted between the connection wiring and the power supply electrode of the laser waveguide, and a multilayer wiring structure is formed.

### CITATION LIST

### PATENT LITERATURE

Patent Literature 1: JP 2000-269601 A
Patent Literature 2: JP 2010-135731 A

### SUMMARY

### PROBLEM TO BE SOLVED

The inventor has studied a multi-beam semiconductor laser element with a narrow beam pitch and has come to recognize the following problem.

Formation of a connection wiring that intersects with a power supply electrode requires a complicated process, and therefore peeling of an interlayer insulating film, the connection wiring, and the like is likely to occur. In particular, the interlayer insulating film and the connection wiring are likely to peel at an upper portion of a base having unevenness, for example, on a ridge, or at a location straddling dissimilar materials having different thermal expansion coefficients.

Such a problem is not limited to the connection wiring in a multi-beam semiconductor laser element, but may also occur in a wiring, a pad, and an insulating film in another semiconductor laser element.

A certain aspect of the present disclosure has been made in view of such a problem, and one of exemplary purposes thereof is to provide a semiconductor laser element in which peeling of an insulating film and a wiring is unlikely to occur.

### SOLUTION TO PROBLEM

A certain aspect of the present disclosure relates to a semiconductor laser element. The semiconductor laser element comprises a laser waveguide. On a surface of the semiconductor laser element, a groove extending in a first direction is formed. The groove includes, in cross-sectional view, a first portion having a relatively narrow width in a second direction, and a second portion located deeper than the first portion and having a relatively wide width in the second direction. In at least a part of the first direction of the groove, a surface of the groove is covered with a metal or an insulating material formed so as to cross the groove in the second direction.

Note that arbitrary combinations of the above-described constituent elements, and those obtained by mutually replacing the constituent elements and expressions of the present disclosure among a method, an apparatus, a system, and the like are also effective as aspects of the present disclosure.

### ADVANTAGEOUS EFFECT

According to a certain aspect of the present disclosure, it is possible to provide a semiconductor laser element in which peeling of an insulating film and a wiring is unlikely to occur.

### BRIEF DESCRIPTION OF THE DRAWINGS

[FIG. 1] A perspective view of a semiconductor laser element according to Embodiment 1.
[FIG. 2] A cross-sectional view of a part of the semiconductor laser element of FIG. 1.
[FIG. 3] An enlarged view of a groove.
[FIG. 4] A cross-sectional view of a groove according to Modification 1.1.
[FIG. 5] A cross-sectional view of a groove according to Modification 1.2.
[FIG. 6] A cross-sectional view of a semiconductor laser element according to Modification 1.3.
[FIG. 7] A cross-sectional view of a semiconductor laser element according to Modification 1.4.
[FIG. 8] A cross-sectional view of a semiconductor laser element according to Modification 1.5.
[FIG. 9] A cross-sectional view of a semiconductor laser element according to Embodiment 2.
[FIG. 10] A cross-sectional view of a groove according to Modification 2.1.

### DESCRIPTION OF EMBODIMENTS

### (Overview of Embodiments)

An overview of several exemplary embodiments of the present disclosure will be described. This overview is intended as a preface to the detailed description described later, or for the purpose of basic understanding of the embodiments. The overview describes some concepts of one or a plurality of embodiments in a simplified manner, and does not limit the breadth of the invention or the disclosure. Also, this overview is not a comprehensive overview of all conceivable embodiments, and does not limit indispensable constituent elements of the embodiments. For convenience, "one embodiment" may be used to refer to one embodiment (example or modification) or a plurality of embodiments (examples or modifications) disclosed in this specification.

A semiconductor laser element according to one embodiment comprises a laser waveguide extending in a first direction. On a surface of the semiconductor laser element, a groove extending in the first direction is formed, and the groove includes, in cross-sectional view, a first portion having a relatively narrow width in a second direction, and a second portion located deeper than the first portion and having a relatively wide width in the second direction. In at least a part of the first direction of the groove, a surface of the groove is covered with a metal or an insulating material formed so as to cross the groove in the second direction.

In one embodiment, the groove may include a protrusion corresponding to the first portion on a side surface thereof.

In one embodiment, the groove may be formed in an epitaxial growth layer, and the first portion and the second portion may differ in material.

In one embodiment, the first portion may be an active layer.

In one embodiment, the first portion may be a contact layer.

In one embodiment, the groove may have a tapered shape in which a width becomes narrower closer to a surface in cross-sectional view.

In one embodiment, a difference in width between the first portion and the second portion may be 10 nm or more and 1 micrometer or less.

In one embodiment, the groove may be deeper than the active layer.

In one embodiment, the groove may be shallower than the active layer.

In one embodiment, the groove may be filled with at least one of a metal and an insulating material.

In one embodiment, the laser waveguide may extend in the first direction.

In one embodiment, the laser waveguide may extend in the second direction. In this case, the groove may be a light-blocking groove.

In one embodiment, a plurality of the laser waveguides may be formed adjacent to each other in the second direction within a laser region on a semiconductor substrate, and a plurality of the grooves may be formed adjacent to the plurality of laser waveguides.

In one embodiment, a power supply electrode may be formed on the plurality of laser waveguides. The semiconductor laser element may further comprise a plurality of connection wirings corresponding to the plurality of laser waveguides, each extending in the second direction and connected to the power supply electrode of a corresponding laser waveguide, and an interlayer insulating film formed to include a location where the connection wiring and the power supply electrode that are to be insulated from each other intersect. A surface of the groove may be covered with the interlayer insulating film or the connection wiring.

### (Embodiments)

Hereinafter, the present disclosure will be described based on preferred embodiments with reference to the drawings. The same or equivalent constituent elements, members, and processes shown in the respective drawings are denoted by the same reference signs, and redundant description will be omitted as appropriate. Also, the embodiments are not intended to limit the disclosure but are illustrative, and all features described in the embodiments and combinations thereof are not necessarily essential to the disclosure.

Dimensions (thickness, length, width, and the like) of respective members described in the drawings may be enlarged or reduced as appropriate for ease of understanding. Furthermore, dimensions of a plurality of members do not necessarily represent their magnitude relationship, and even if a certain member A is drawn thicker than another member B in the drawings, the member A may be thinner than the member B.

### (Embodiment 1)

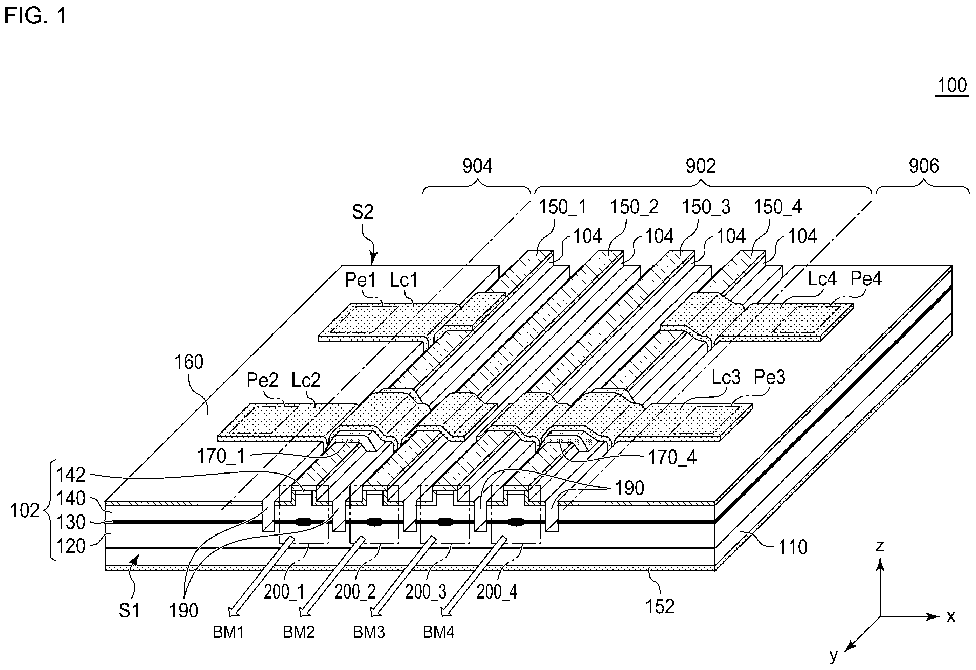

FIG. 1 is a perspective view of a semiconductor laser element 100 according to Embodiment 1. The semiconductor laser element 100 is an edge-emitting semiconductor laser element and is a multi-beam semiconductor laser including a plurality of m (m >= 3) emitters. In the present embodiment, the number m of emitters is four.

The semiconductor laser element 100 comprises an N-type semiconductor substrate 110 and an epitaxial growth layer 102 formed on the N-type semiconductor substrate 110. The epitaxial growth layer 102 includes an N-type cladding layer 120, a light-emitting layer (active layer) 130, a P-type cladding layer 140, and a P-type contact layer 142, and is stacked in order on the N-type semiconductor substrate 110. The light-emitting layer 130 includes an N-type guide layer (lower guide layer), an active layer composed of a quantum well layer, and a P-type guide layer (upper guide layer). Materials of the N-type semiconductor substrate 110 and the epitaxial growth layer 102 may be selected according to a required oscillation wavelength, and are not particularly limited in the present disclosure.

The semiconductor laser element 100 includes a central laser region 902 and pad regions 904, 906. In the laser region 902, m (m >= 3) stripe-shaped laser waveguides 200_1 to 200_m, each extending in a first direction (y-direction) and adjacent to each other in a second direction (x-direction), are formed.

In the epitaxial growth layer 102, a waveguide structure for confining light is formed, and cleaved facets at both ends of the waveguide structure serve as mirrors, forming a Fabry-Perot type laser waveguide 200. In this example, four laser waveguides 200_1 to 200_4 are formed, and beams BM1 to BM4 are emitted in the y-direction from a front end facet (emission end facet) S1. On the front end facet S1 and a rear end facet S2 of each laser waveguide 200, coating is applied to provide a desired reflectance.

In the present embodiment, the waveguide structure is a ridge waveguide, and in the P-type cladding layer 140 of the epitaxial growth layer 102, a ridge structure (mesa structure) 104 extending in the y-direction is formed.

On an upper surface of the semiconductor laser element 100, a contact insulating film 160 is formed. In the contact insulating film 160, a rectangular opening having the y-direction as a longitudinal direction is formed on an upper surface of the laser waveguides 200_1 to 200_m, specifically on an upper surface of the ridge structure 104. A power supply electrode (P-side electrode) 150 is formed along the opening and connected to the P-type contact layer 142. To enable independent driving of the laser waveguides 200, the power supply electrodes 150 are electrically insulated from each other. Also, a P-type semiconductor portion includes electrical resistance between respective emitters, enabling electrically independent driving. In the present embodiment, the power supply electrode 150 is a stripe-shaped electrode extending along the y-direction on the upper surface of the laser waveguide 200.

On a back surface of the laser waveguide 200, an N-side electrode 152 is formed.

For power supply to the laser waveguide 200, a plurality of chip-side electrode pads (hereinafter simply referred to as electrode pads) Pe1 to Pe4 and a plurality of connection wirings Lc1 to Lc4 are provided corresponding to the plurality of laser waveguides 200_1 to 200_4.

The plurality of electrode pads Pe1 to Pe4 are formed in the pad regions 904, 906 adjacent to the laser region 902 in the x-direction. To the electrode pads Pe1 to Pe4, a bonding wire is connected in the case of junction-up mounting, and solder is connected in the case of junction-down mounting.

Each connection wiring Lci (i = 1, 2, 3, 4) electrically connects the power supply electrode 150 of a corresponding laser waveguide 200_i and a corresponding electrode pad Pei.

Among the plurality of laser waveguides 200_1 to 200_4, for the two inner ones (200_2, 200_3), the connection wirings Lc2, Lc3 cross the power supply electrode 150 of an outer laser waveguide 200. Specifically, the connection wiring Lc2 crosses the power supply electrode 150_1 of the laser waveguide 200_1. Similarly, the connection wiring Lc3 crosses the power supply electrode 150_4 of the laser waveguide 200_4.

An interlayer insulating film 170 is formed to include a location where the connection wiring Lc and the power supply electrode 150 that are to be insulated from each other intersect, and ensures electrical insulation between the connection wiring Lc2 and the power supply electrode 150_1 as well as electrical insulation between the connection wiring Lc3 and the power supply electrode 150_4.

In the present embodiment, the interlayer insulating film 170 is provided independently for each location where the connection wiring Lc and the power supply electrode 150 intersect. Specifically, an interlayer insulating film 170_1 is provided at a location where the connection wiring Lc2 intersects the power supply electrode 150_1, and an interlayer insulating film 170_4 is provided at a location where the connection wiring Lc3 intersects the power supply electrode 150_4.

On the upper surface of the semiconductor laser element 100, at least one stripe-shaped groove 190 extending in the first direction (y-direction) is formed. In this example, a groove 190 is formed adjacent to each laser waveguide 200. The groove 190 has a function of suppressing peeling of an insulating film, a wiring, and a pad formed on the upper surface of the semiconductor laser element 100, as described below. Note that the groove 190 may also serve as a separation groove that thermally and/or electrically separates adjacent laser waveguides 200.

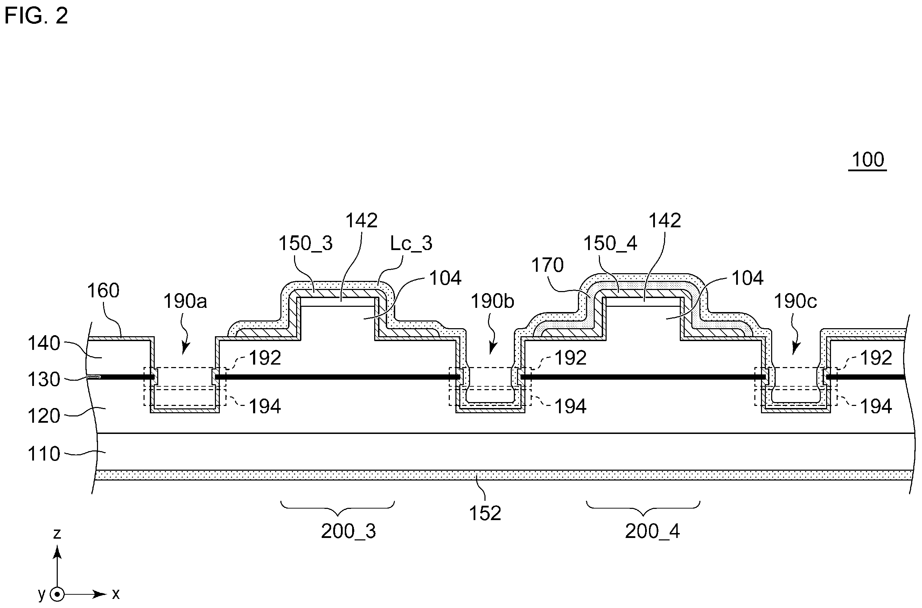

FIG. 2 is a cross-sectional view of a part of the semiconductor laser element 100 of FIG. 1. The groove 190 includes, in cross-sectional view, a first portion 192 having a relatively narrow width in the second direction (x-direction), and a second portion 194 located deeper than the first portion 192 and having a relatively wide width in the second direction. The first portion 192 is a protrusion structure protruding from a side surface of the groove having a rectangular cross section. When the semiconductor laser element 100 is viewed in plan view along the z-direction, a part of a bottom surface of the groove 190 is hidden by the protrusion portion. A difference in width between the first portion 192 and the second portion 194 is preferably 10 nm or more and 1 micrometer or less.

In the present embodiment, in at least a part of the y-direction, a surface of at least one groove 190 is continuously covered in a direction crossing the groove 190, that is, in the x-direction, by any one of a metal, an inorganic insulating material, and an organic insulating material. In FIG. 2, surfaces of a plurality of grooves 190a to 190c are covered with the contact insulating film 160. Furthermore, in the grooves 190b, 190c, the connection wiring Lc3 is formed on the contact insulating film 160.

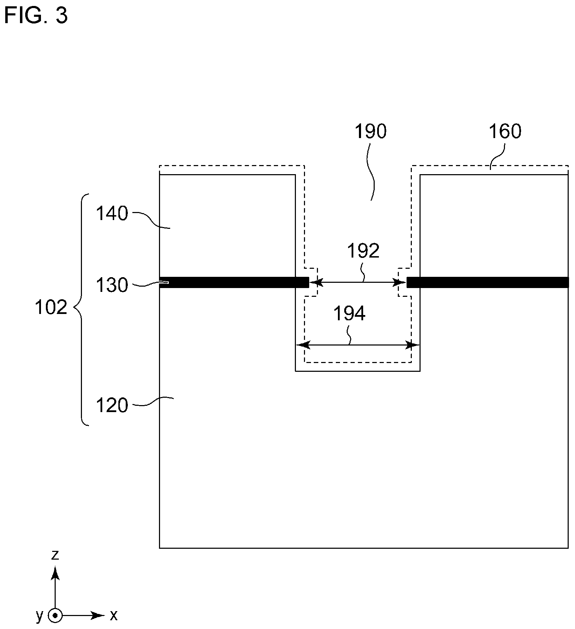

FIG. 3 is an enlarged view of the groove 190. The groove 190 is formed in the epitaxial growth layer 102 of a crystalline material, and the first portion 192 and the second portion 194 differ in material. After the epitaxial growth layer 102 is formed and before the contact insulating film 160 is formed, the groove 190 is formed by etching. At this time, by utilizing the fact that etching rates differ between dissimilar materials, it is possible to form the first portion 192, which is the protrusion structure, and the second portion 194. In the example of FIG. 3, a depth of the groove 190 is deeper than the light-emitting layer 130. The first portion 192 is the light-emitting layer 130, and the second portion 194 is the N-type cladding layer 120. Here, the difference in width between the first portion 192 and the second portion 194 is preferably 10 nm or more and 1 micrometer or less. Because the difference in width between the first portion 192 and the second portion 194 is within the aforementioned dimensional range, even in response to stress in a chip upper surface direction being introduced into the contact insulating film, the film within the groove is caught by the protrusion within the groove, so that film peeling is suppressed. At this time, in response to the difference in width between the first portion 192 and the second portion 194 being small, a sufficient peeling prevention effect is not obtained. Also, in response to the difference in width between the first portion 192 and the second portion 194 being too large, it becomes difficult to obtain sufficient coverage of the film at the protrusion, and peeling rather tends to occur.

The above is the configuration of the semiconductor laser element 100.

According to the semiconductor laser element 100, in the grooves 190a to 190c, the first portion 192 having the protrusion shape and the contact insulating film 160 engage with each other. That is, the first portion 192 functions as an anchor that enhances adhesion. Therefore, the combination of the first portion 192 and the second portion 194 is referred to as an anchor structure, and a groove having the anchor structure is also referred to as an anchor groove.

Furthermore, by forming the contact insulating film 160 thinly, it is possible to provide the contact insulating film 160 with unevenness conforming to a shape of a base of the grooves 190a to 190c. Thereby, in the grooves 190b and 190c, the first portion 192 also functions as an anchor that enhances adhesion of the connection wiring Lc.

Next, modifications will be described.

### (Modification 1.1)

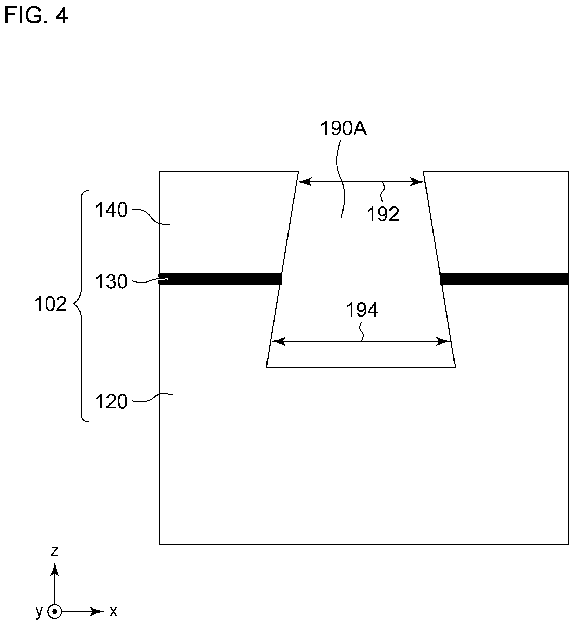

FIG. 4 is a cross-sectional view of a groove 190A according to Modification 1.1. In Modification 1.1, the groove 190A is formed in the epitaxial growth layer 102, similarly to FIG. 3. A cross-sectional shape of the groove 190A is trapezoidal, and has a tapered shape in which a width becomes wider as the groove becomes deeper. In this structure, a shallowest part of the groove 190A is the first portion 192, and a deepest part is the second portion 194. In FIG. 4, a depth of the groove 190A is deeper than the light-emitting layer 130, but may be shallower than the light-emitting layer 130.

### (Modification 1.2)

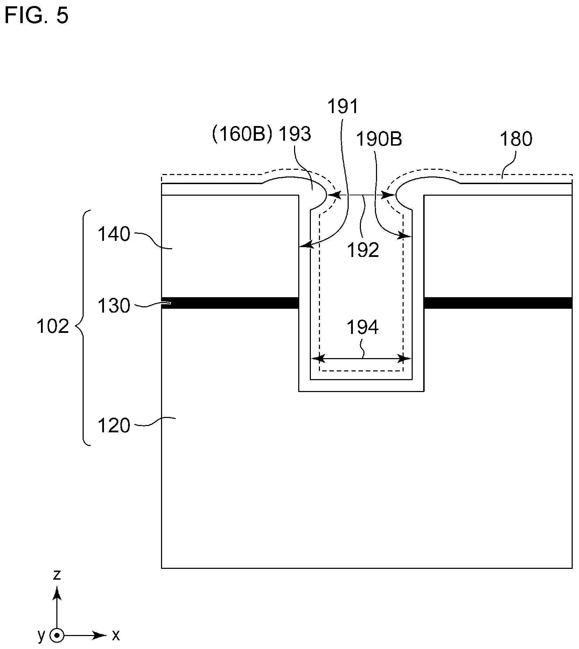

FIG. 5 is a cross-sectional view of a groove 190B according to Modification 1.2. In Modification 1.2, in the epitaxial growth layer 102, a groove 191 having a rectangular cross section is formed, and an anchor structure composed of the first portion 192 and the second portion 194 is formed by an insulating layer 193 thereon. For example, the insulating layer 193 having the anchor structure is formable with the contact insulating film 160. The contact insulating film 160 may be a CVD insulating film (CVD oxide film) formed by a chemical vapor deposition (CVD) method, or may be formed by a sputtering method or an atomic layer deposition (ALD) method.

In the present example, after the groove 191 is formed, the CVD insulating film, which is the contact insulating film 160, is formed. The CVD insulating film has a property that a deposition rate at a corner portion is higher than a deposition rate at a flat portion. Therefore, the CVD insulating film has a protrusion structure at a corner portion of an entrance of the groove 191, and is capable of forming the first portion 192 having a narrow width. In FIG. 5, the groove 190B is deeper than the light-emitting layer 130, but is not limited thereto, and the groove 190B may be shallower than the light-emitting layer 130.

Then, by forming another insulating film or wiring 180 on the CVD insulating film having the protrusion structure, another insulating film or wiring 180 becomes unlikely to peel. Note that the CVD insulating film has high adhesion to the semiconductor material that is the base, and therefore sufficient adhesion strength is obtainable for the groove having the rectangular cross section, and a possibility of peeling is low.

### (Modification 1.3)

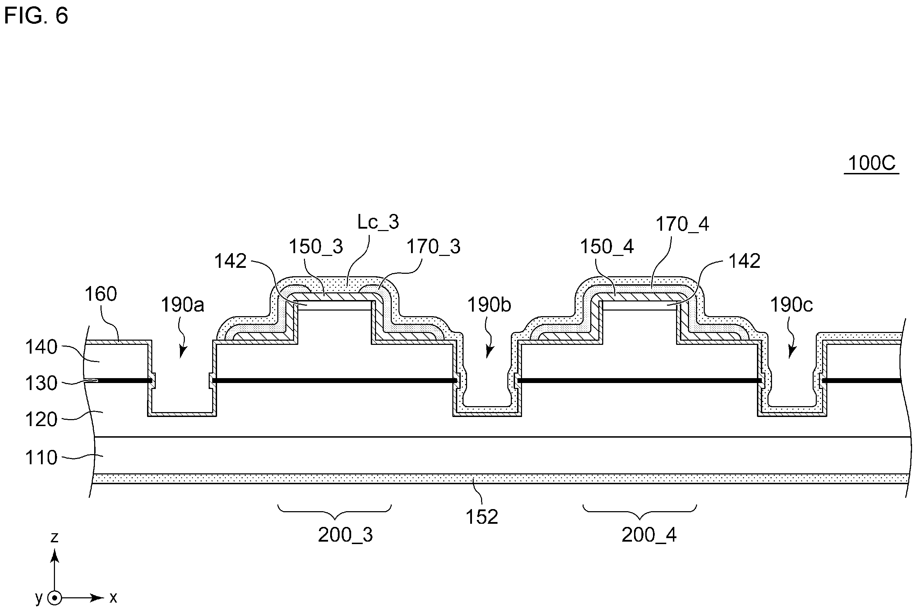

FIG. 6 is a cross-sectional view of a semiconductor laser element 100C according to Modification 1.3. In this modification, an interlayer insulating film 170 is formed on each laser waveguide 200. In the interlayer insulating film 170_i (i = 1, 2, 3, 4), an opening is formed at a location where a corresponding connection wiring Lc_i and a corresponding power supply electrode 150_i are to be connected.

According to the Modification 1.3, by forming the connection wiring Lc3 along the grooves 190b, 190c, it is possible to enhance adhesion to the contact insulating film 160, and it is possible to make peeling unlikely.

### (Modification 1.4)

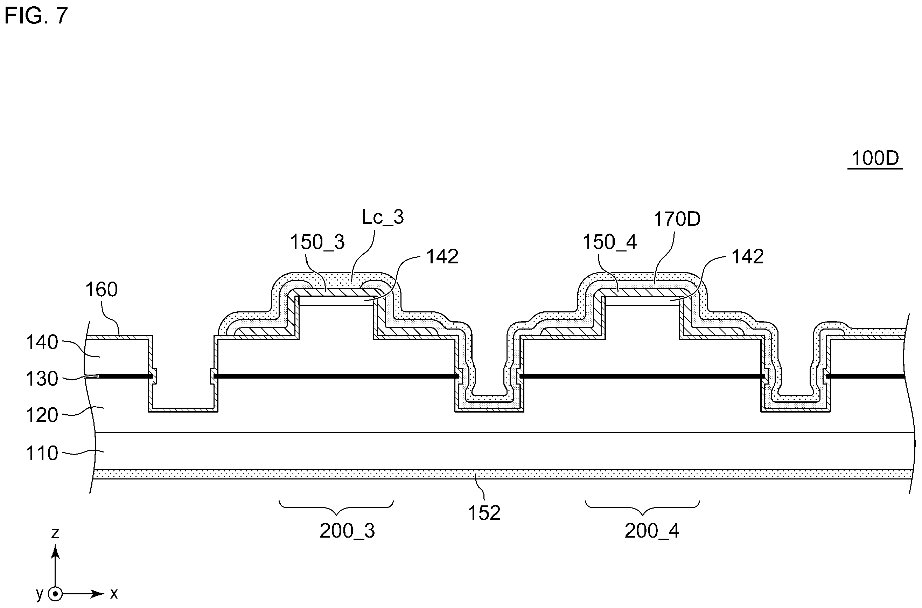

FIG. 7 is a cross-sectional view of a semiconductor laser element 100D according to Modification 1.4. In this modification, similarly to FIG. 6, the plurality of laser waveguides 200 are covered with an interlayer insulating film 170D. A difference from FIG. 6 is that the interlayer insulating film 170D is continuous.

In this configuration, the interlayer insulating film 170D is formed along the grooves 190b, 190c. Therefore, compared to the configuration of FIG. 6, the interlayer insulating film 170D is unlikely to peel. Furthermore, the connection wiring Lc3 is also formed on the interlayer insulating film 170D along the grooves 190b, 190c, and therefore is unlikely to peel.

### (Modification 1.5)

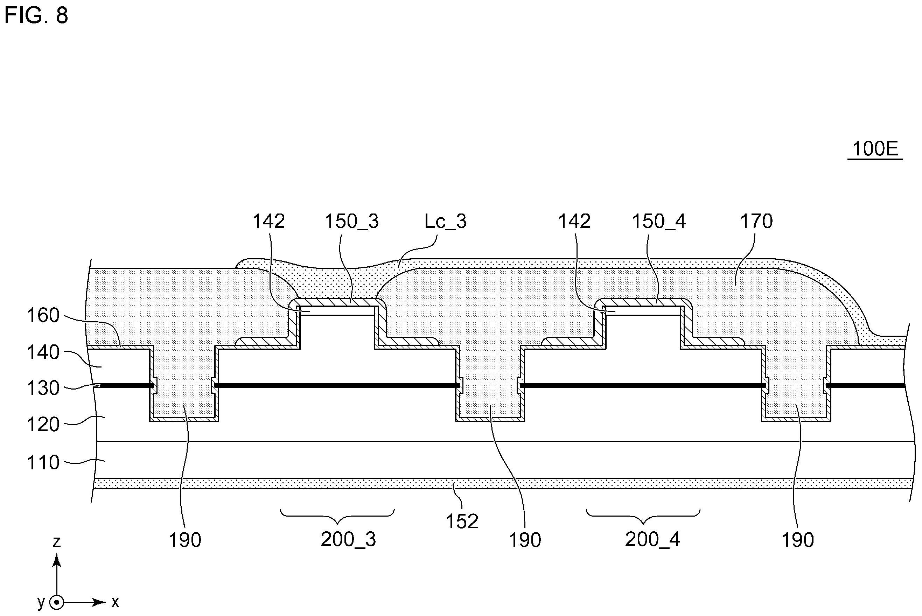

FIG. 8 is a cross-sectional view of a semiconductor laser element 100E according to Modification 1.5. In this modification, similarly to FIG. 7, an interlayer insulating film 170E is continuously formed across the plurality of laser waveguides 200. A difference from FIG. 7 is that the groove 190 is filled with the interlayer insulating film 170E. According to this configuration, it is possible to further enhance adhesion of the interlayer insulating film 170E to the epitaxial growth layer 102.

### (Embodiment 2)

In Embodiment 1 and the modifications thereof, a ridge-type waveguide has been described, but a structure of the waveguide is not limited thereto.

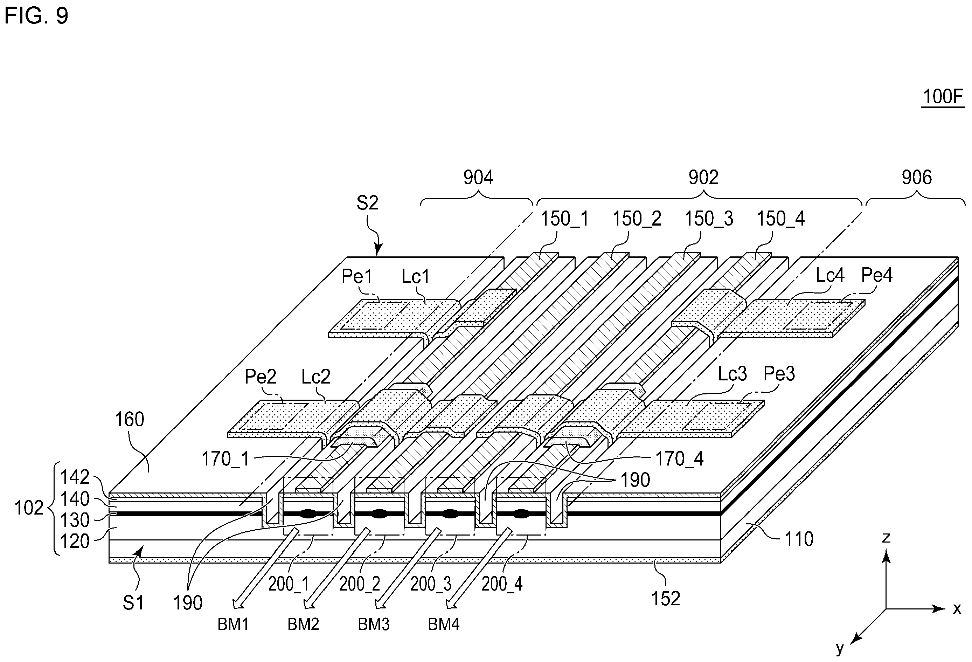

FIG. 9 is a cross-sectional view of a semiconductor laser element 100F according to Embodiment 2. In FIG. 9, the laser waveguide 200 does not include the ridge structure 104.

A structure of the groove 190 in Embodiment 2 is not particularly limited, and the structure of the groove 190 described in Embodiment 1 is adoptable.

According to Embodiment 2, similarly to Embodiment 1, it is possible to make peeling of an insulating film and a wiring unlikely to occur. Next, a modification related to Embodiment 2 will be described.

### (Modification 2.1)

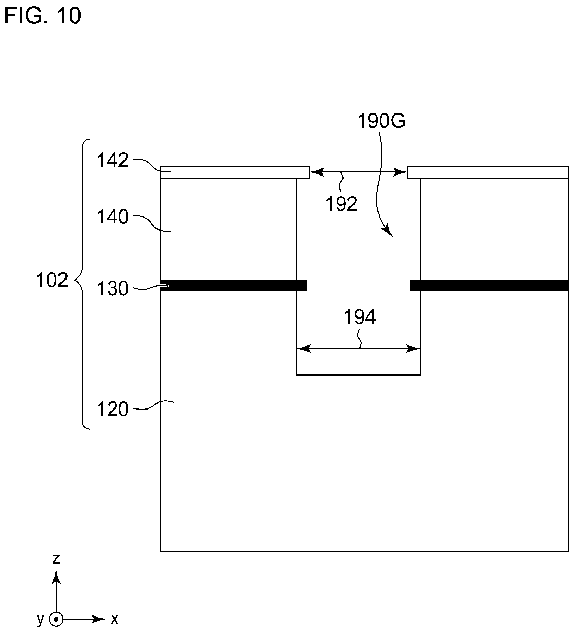

FIG. 10 is a cross-sectional view of a groove 190G according to Modification 2.1. In Embodiment 1 and the modifications thereof, since the ridge structure 104 is included, the groove was formed in the P-type cladding layer 140 at a portion where the P-type contact layer 142 was removed. In contrast, in Embodiment 2, the P-type contact layer 142 remains on a surface layer of the semiconductor laser element 100. In Modification 2.1, the groove 190G is formed in the epitaxial growth layer 102 of a crystalline material including the P-type contact layer 142, and the first portion 192, which is the protrusion structure, is formed utilizing the P-type contact layer 142.

Since the P-type contact layer 142 and the P-type cladding layer 140 are dissimilar materials, they have different etching rates. For example, the P-type cladding layer 140 is GaAs, and the N-type cladding layer 120 is AlInP, and an etching rate of GaAs is lower. Therefore, the first portion 192 is formable by the P-type cladding layer 140.

### (Other Modifications)

The above-described embodiments are illustrative, and it is understood by those skilled in the art that various modifications are possible in combinations of the respective constituent elements and the respective processing processes. Hereinafter, such modifications will be described.

In the foregoing description, prevention of peeling of the connection wiring Lc and the interlayer insulating film 170 serving as a base thereof in the multi-beam semiconductor laser element has been described, but application of the technology according to the present disclosure is not limited thereto. In addition to the connection wiring Lc and the interlayer insulating film 170, when a wiring or an insulating film that is likely to peel is present, the groove 190 having the anchor structure is formed in a periphery thereof, and the wiring or the insulating film is continuously formed along the groove 190, thereby making peeling unlikely. For example, to suppress peeling of the electrode pad Pe, the groove 190 may be formed along a formation region of the electrode pad Pe, and the electrode pad Pe may be extended so as to cross the groove 190.

Not limited to the multi-beam semiconductor laser element, the technology according to the present disclosure is also applicable to a single-beam semiconductor laser element when a wiring or an insulating film that is likely to peel is present.

Some semiconductor laser elements comprise a bank adjacent to the laser waveguide. On an emission end facet side, a light-blocking groove for blocking leakage of light from the bank may be provided. In this case, the light-blocking groove may comprise the anchor structure as described in the embodiments.

Although the embodiments according to the present disclosure have been described using specific terms, this description is merely illustrative for aiding understanding, and does not limit the present disclosure or the claims. The scope of the invention is defined by the claims, and therefore embodiments, examples, and modifications not described herein are also included in the scope of the invention.

### REFERENCE SIGNS

100 semiconductor laser element
102 epitaxial growth layer
104 ridge structure
S1 front end facet
S2 rear end facet
902 laser region
904, 906 pad region
110 N-type semiconductor substrate
120 N-type cladding layer
130 light-emitting layer
140 P-type cladding layer
160 contact insulating film
Pe electrode pad
Lc connection wiring
150 power supply electrode
152 N-side electrode
154 contact insulating film
170 interlayer insulating film
200 laser waveguide

## Claims

1. A semiconductor laser element comprising:
a laser waveguide,
wherein a groove extending in a first direction is formed on a surface of the semiconductor laser element,
the groove comprises, in cross-sectional view, a first portion having a relatively narrow width in a second direction, and a second portion located deeper than the first portion and having a relatively wide width in the second direction, and
in at least a part of the first direction of the groove, a surface of the groove is covered with a metal or an insulating material formed so as to cross the groove in the second direction.

2. The semiconductor laser element according to claim 1, wherein the groove comprises a protrusion corresponding to the first portion on a side surface thereof.

3. The semiconductor laser element according to claim 2, wherein the groove is formed in an epitaxial growth layer, and the first portion and the second portion differ in material.

4. The semiconductor laser element according to claim 3, wherein the first portion is an active layer.

5. The semiconductor laser element according to claim 3, wherein the first portion is a contact layer.

6. The semiconductor laser element according to claim 1, wherein the groove has a tapered shape in which a width becomes narrower closer to a surface in cross-sectional view.

7. The semiconductor laser element according to any one of claims 1 to 6, wherein a difference in width between the first portion and the second portion is 10 nm or more and 1 micrometer or less.

8. The semiconductor laser element according to any one of claims 1 to 6, wherein the groove is deeper than an active layer.

9. The semiconductor laser element according to any one of claims 1 to 3, wherein the groove is shallower than an active layer.

10. The semiconductor laser element according to any one of claims 1 to 6, wherein the groove is filled with at least one of a metal and an insulating material.

11. The semiconductor laser element according to any one of claims 1 to 6, wherein the laser waveguide extends in the first direction.

12. The semiconductor laser element according to claim 11, wherein a plurality of the laser waveguides are formed adjacent to each other in the second direction within a laser region on a semiconductor substrate, and
a plurality of the grooves are formed adjacent to the plurality of laser waveguides.

13. The semiconductor laser element according to any one of claims 1 to 6, wherein a power supply electrode is formed on a plurality of the laser waveguides,
the semiconductor laser element further comprising:
a plurality of connection wirings corresponding to the plurality of laser waveguides, each extending in the second direction and connected to the power supply electrode of a corresponding laser waveguide; and
an interlayer insulating film formed to include a location where the connection wiring and the power supply electrode that are to be insulated from each other intersect,
wherein a surface of the groove is covered with the interlayer insulating film or the connection wiring.
